# EUROPÄISCHE PATENTSCHRIFT

(11) **EP 2 228 464 B1**
(45) Veröffentlichungstag und Bekanntmachung des Hinweises auf die Patenterteilung: **26.12.2012**
(21) Anmeldenummer: 10155360.0
(22) Anmeldetag: 03.03.2010
(51) Int. Cl.: C23C 14/34, B23D 23/00

(54) **Indium-Target für Sputtereinrichtungen sowie Anordnung und Verfahren zur Herstellung solcher Indium-Targets**
Indium target for sputtering device and assembly and method for producing such indium targets
Cible d'indium pour dispositifs de pulvérisation et dispositif et procédé de fabrication de tels cibles d'indium

(30) Priorität: 03.03.2009 DE 102009015489; 04.03.2009 DE 102009011161; 28.08.2009 DE 102009037328
(43) Veröffentlichungstag der Anmeldung: 15.09.2010
(73) Patentinhaber: FHR Anlagenbau GmbH, 01458 Ottendorf-Okrilla (DE)
(72) Erfinder: Ränsch, Christian, 01445 Radebeul (DE); Böhling, Marian, 01129 Dresden (DE); Derlitzki, Ulrich, 01099 Dresden (DE); Hesse, Gregor, 01307 Dresden (DE)
(74) Vertreter: Hudler, Frank

(56) Entgegenhaltungen:
- US-A1- 2009 045 050
- DHERE NEELKANTH G ET AL: "Development of sputtering systems for large-area deposition of CuIn1-xGaxSe1-ySy thin-film solar cells" JOURNAL OF VACUUM SCIENCE AND TECHNOLOGY: PART A, Bd. 21, Nr. 4, 2. Juli 2003 (2003-07-02), Seiten 1442-1446, XP012006455 AVS /AIP, MELVILLE, NY [US] ISSN: 0734-2101 DOI: 10.1116/1.1577128
- SEEGER S ET AL: "Reactive magnetron sputtering of CuInS2 absorbers for thin film solar cells: Problems and prospects" THIN SOLID FILMS, Bd. 517, Nr. 10, 25. November 2008 (2008-11-25), Seiten 3143-3147, XP026005695 ELSEVIER-SEQUOIA S.A. LAUSANNE [CH] ISSN: 0040-6090 DOI: 10.1016/J.TSF.2008.11.120 [gefunden am 2008-11-25]
- ELLMER K ET AL: "Copper indium disulfide solar cell absorbers prepared in a one-step process by reactive magnetron sputtering from copper and indium targets" THIN SOLID FILMS, Bd. 413, Nr. 1-2, 17. Mai 2002 (2002-05-17), Seiten 92-97, XP004369913 ELSEVIER-SEQUOIA S.A. LAUSANNE [CH] ISSN: 0040-6090 DOI: 10.1016/S0040-6090(02)00355-3

## Beschreibung

Die Erfindung betrifft ein Indium-Target für Sputtereinrichtungen aus ultra-feinkörnigem Gefüge zur Herstellung von Oberflächenbeschichtungen durch Sputtern, enthaltend einen mit einem Kühlkreislauf verbindbaren Kühlkörper mit mindestens einer Vertiefung, die mit Indium verfüllt ist, wobei sich das Indium auf einer Seite des Kühlkörpers über dessen gesamte Breite und Länge erstreckt und ein Verfahren zur Herstellung solcher Indium-Targets.

Derartige in der Praxis eingesetzte Indium-Targets zur Beschichtung von Substraten mit 4 m Breite und 6 m Länge haben derzeit eine Länge von mehr als 4 m und eine Bereite um 0,5 bis 1 m und bestehen aus einer Kühlplatte, sowie einer in deren Oberfläche eingearbeiteten flachen Vertiefung zur Aufnahme von geschmolzenem Indium. Das Indium muss nach der Erstarrung die gesamte Oberseite der Kühlplatte, also auch deren Rand, überdecken, so dass eine geschlossene Indiumfläche entsteht, um zu gewährleisten, dass beim Einsatz des Indium-Targets ausschließlich Indium abgesputtert wird.

Aus diesem Grund wird die Kühlplatte während des Gießvorganges und während der nachfolgenden Abkühlung temporär von einem umlaufenden Gießrand umgeben, der nach dem Erstarren des Indiums wieder entfernt wird. Da das Indium nach dem Gießen möglichst schnell abkühlen soll, sind in die Kühlplatte Kühlkanäle eingebracht, die in Verbindung mit einem Wasserkreislauf für die nötige Kühlung sorgen.

Der Schmelzpunkt von Indium beträgt 156,6 °C, das bedeutet, dass die Kühlplatte vor dem Gießvorgang mindestens auf diese Temperatur erwärmt und nachfolgend möglichst schnell auf Raumtemperatur abgekühlt werden muss.

Problematisch sind hier die Abmessungen der Indium-Targets, insbesondere dessen Länge, was bedeutet, dass über deren gesamte Länge eine gleichmäßige Abkühlung erreicht werden muss, so dass Kühlkanäle über die gesamte Länge und Breite des Kühlkörpers eingebracht werden müssen, was sehr aufwändig ist. Andererseits bereitet die zu Beginn des Abkühlvorganges für eine Wasserkühlung hohe Temperatur Schwierigkeiten. Das bedeutet, dass es beim Einleiten des Wassers in den Kühlkörper zu einer Überhitzung kommt, was zu einem schlagartigen Verdampfen des Wassers führt. Die dabei entstehenden Erschütterungen können zu Störungen im Gefüge des Indiums führen.

Schließlich muss beim Abkühlungsvorgang erreicht werden, dass ein möglichst feinkörniges Indiumgefüge entsteht, um während des Einsatzes der Targets die Neigung zu Funkenentladungen, die mit einem zusätzlichen Energieeintrag und zu Störungen des Sputtervorganges einhergehen würden, zu verringern.

Beim Einsatz der Indium-Targets in Sputtereinrichtungen müssen diese wegen des erheblichen Energieeintrages ebenfalls über einen Kühlwasserkreislauf gekühlt werden, wozu üblicherweise die im Kühlkörper ohnehin verwendeten Kühlkanäle verwendet werden.

Problematisch beim Einsatz der Targets, wie auch beim Gießen des Indiums, ist jedoch, dass eine möglichst große Kühlleistung bereitgestellt werden muss. Folglich müssen die Kühlkanäle einen möglichst großen Querschnitt aufweisen, was wiederum die Fertigungskosten erheblich erhöht und dem durch die geometrischen Abmessungen der Kühlkörper Grenzen gesetzt werden.

Weiterhin wird die Qualität der auf einem Substrat gesputterten Indiumschicht maßgeblich durch die Körnigkeit des Indiums im Indium-Target bestimmt. Je kleiner die Körnigkeit des Indiums ist, umso hochwertigere Indiumschichten können gesputtert werden.

Aus DHERE NEELKANTH G ET AL: "Development of sputtering systems for large-area deposition of CuIn1-XGAXSe1-YSY thinfilm solar cells" JOURNAL OF VACUUM SCIENCE AND TECHNOLOGY: PART A, Bd. 21, Nr. 4, 2. Juli 2003 (2003-07-02), Seiten 1442 - 1446, XP012006455 AVS /AIP, MELVILLE, NY [US] ISSN: 0734-2101 DOI: 10.1116/1.1577128 geht eine Targetanordnung, hervor, die auf einem Cu-Magnetronkörper mittels Targetklammern befestigt ist, wobei der Cu-Magnetronkörper erhen Kühlkanal aufweist, de mit einen Wasserstrom beanfschlagt ist.

In der US 2009/045050 A1 (KUNIYA TSUTOMU [JP] ET AL) 19. Februar 2009 (2009-02-19) wird eine Targetstruktur zum Sputtern beschrieben, bei der ein flächiges Sputtertarget auf einer Flachen Stützplatte aus Metall durch Bonden befestigt ist. In der Stützplatte befinden sich Edelstahlrohre für Kühlzwecke.

Der Erfindung liegt nun die Aufgabe zugrunde, ein Indium-Taget sowie eine Anordnung und ein Verfahren zur Herstellung solcher Indium-Targets mit der nötigen Feinkörnigkeit zu schaffen, bei dem sowohl während des Gießvorganges, als auch beim Einsatz in Sputtereinrichtungen eine besonders gute Kühlleistung gewährleistet wird, so dass eine Erhöhung der Standzeit der Indium-Targets beim Sputtern sowie eine deutliche Verbesserung der Qualität der gesputterten Schichten sowie eine Erhöhung der Sputterraten erreicht werden kann.

Die der Erfindung zugrunde liegende Aufgabe wird bei einem Indium-Target für Sputtereinrichtungen aus ultra-feinkörnigem Gefüge zur Herstellung von Oberflächenbeschichtungen durch Sputtern im Vakuum, enthaltend einen mit einem Kühlkreislauf verbindbaren Kühlkörper mit mindestens einer Vertiefung, die mit Indium verfüllt ist, wobei sich das Indium auf einer Seite des Kühlkörpers über dessen gesamte Breite und Länge erstreckt, dadurch gelöst, dass der Kühlkörper flach ausgebildet ist und unterhalb der sich im Gebrauch der Indium-Targets ausbildenden Sputtergräben unter jedem derselben mit einer zu diesem im wesentlichen formkongruenten in die Tiefe gehenden Aussparung versehen ist und wobei die Kühleinrichtung in Form von mit dem Kühlkörper verbundenen Kühlkanälen ausgebildet ist, wobei die Kühlkanäle auf der Unterseite des Kühlkörpers angeordnet sind.

Mit der erfindungsgemäßen Ausgestaltung des Indium-Targets gelingt es erstmalig, eine besonders gute Kühlleistung insbesondere durch die Aussparungen in Verbindung mit den Kühlkanälen außerhalb des Kühlkörpers bereitzustellen.

Daraus resultiert die Möglichkeit, Indium-Targets ultra-feinkörnigem Gefüge herzustellen. Darüber hinaus erlaubt die Gestaltung der Aussparungen im Kühlkörper in Verbindung mit der Kühlleistung eine wesentlich bessere Ausnutzung der Targets, d.h. eine signifikante Erhöhung der Standzeit.

In einer ersten Ausgestaltung der Erfindung sind die Seitenwände der Aussparung treppenförmig abgestuft und zwar derart, dass die Mittellinie der Abstufungen die Form des Sputtergrabens abbildet und wobei zwischen zwei Aussparungen ein Steg ausgebildet wird. Damit wird die Form der Sputtergräben angenähert realisiert, was bei verringertem Aufwand zu nahezu dem gleichen Ergebnis führt.

Die Aussparungen im Kühlkörper können spanabhebend, insbesondere durch Fräsen oder durch Formfräsen hergestellt werden.

Weiterhin weisen die Kühlkanäle einen rechteckigen Querschnitt auf und sind mit dem Kühlkörper fest verbunden.

Schließlich ist es von Vorteil, wenn die Kühlkanäle, der Kühlkörper und der Gießrahmen aus dem gleichen gut wärmeleitenden Material, wie Kupfer, bestehen. Auf diese Weise werden z.B. während des Aufheizvorganges sonst zu befürchtende Verwerfungen infolge thermischer Spannungen vermieden. Das ist umso wichtiger, da bei der Länge der Indium-Targets bereits geringste Verwerfungen zu Schwierigkeiten beim Gießen führen würden, da der Gießvorgang eine absolut horizontale Planlage des Kühlkörpers und des Gießrahmens voraussetzt.

Im Interesse eines guten Wärmeüberganges sind die Kühlkanäle, die sich über die gesamte Länge des Kühlkörpers erstrecken und mindestens in zwei Teilkreisläufe aufgeteilt sind mit diesem verlötet, wobei der Kühlwasserzu- und Ablauf in der Mitte zwischen den beiden Kühlkreisläufen angeordnet ist.

Die erfindungsgemäß ausgestatteten Indium-Targets können vorteilhaft für die Abscheidung von Indium auf Substraten durch Sputtern mit äußerst hoher Schichtqualität für CIGS-Anwendungen, also für die Herstellung halbleitender Schichten in der Solartechnik verwendet werden.

Die der Erfindung zugrunde liegende Aufgabe wird auch durch eine Anordnung zum Herstellen von Indium-Targets mit ultra-feinkörnigem Gefüge gelöst, bei der auf einer Heizbank mit stabilem Unterbau ein mit in die Tiefe gehenden Aussparungen und auf dessen Unterseite aufgelöteten Kühlkanälen versehener flacher Kühlkörper positioniert ist, der durch einen Gießrahmen umgeben wird, wobei der Kühlkörper und die Kühlkanäle aus dem gleichen gut Wärme leitendem Material bestehen, wobei die Kühleinrichtung mit einem Kühlkreislauf verbindbar ist und wobei die Heizbank mit formschlüssig in diese eingefügten und längs verschieblichen Heizelementen zur Ausbildung eines Temperaturprofiles mit homogener Temperaturverteilung über die Länge des Kühlkörpers versehen ist.
Die Kühlkörper, die Kühlplatte und der Gießrahmen bestehen aus Kupfer, wodurch eine besonders gute Wärmeleitfähigkeit gewährleistet ist.

Die der Erfindung zugrunde liegende Aufgabe wird ferner durch ein Verfahren zum Herstellen von Indium-Targets mit ultra-feinkörnigem Gefüge gelöst, das gekennzeichnet ist durch Aufheizen der Heizbank mit aufliegendem Kühlkörper, der mit längs verlaufenden Aussparungen versehen ist, die formkongruent sind mit den beim Gebrauch entstehenden Sputtergräben, auf die Gießtemperatur von Indium sowie bündiges Einfüllen von flüssigem Indium in den Gießrahmen, Hindurchleiten einer Kühlflüssigkeit durch die Kühlkanäle unmittelbar nach Beendigung des Gießprozesses sowie computergesteuerte Abkühlung der Kühlplatte durch Steuerung von Menge und Geschwindigkeit des durch die Kühlkanäle gepumpten Kühlmediums durch Steuerung der Pumpenleistung.

Die erfindungsgemäß mit gesteuertem Abkühlprozess hergestellten Indium-Targets sind zur Anwendung mit hoher Sputter-Leistung besonders geeignet.

Das ist dadurch möglich, dass solche Indium-Targets mit ultra-feinkörnigem Gefüge eine besonders geringe Neigung zu Funkenentladungen (very low arcing) haben und Sputterraten mit 21,4 nm x m/min mit >1W/cm² bis 3W/cm² erlauben.

Die Geschwindigkeit der Abkühlung der Indiumschmelze kann durch die Menge/Geschwindigkeit des Kühlmediums, das durch die Kühlkanäle gepumpt werden kann und durch dessen Temperatur mittels Steuerung der Temperatur des Kühlmediums und durch Steuerung der Pumpenleistung gesteuert werden.

Durch die Steuerung der Abkühlgeschwindigkeit ist es möglich, ultra-feinkörnige Indium-Targets herzustellen, die wiederum für den Schichtaufbau von Precursorschichten auf Substraten durch Sputtern der Indiumschicht besonders geeignet sind.

Die Precursorschichten können dann später thermisch in halbleitende CIGS-Schichten (Copper-Indium-Gallium-Di Selenid (oder CIS-Schwefel)-Schichten) für Solarzellen umgewandelt werden.

Durch die infolge der Erfindung erheblich verbesserte Schichtqualität der Indium-Schicht wird eine deutliche Verbesserung des Wirkungsgrades der Solarzellen insgesamt erreicht.

Die Erfindung soll nachfolgend an einem Ausführungsbeispiel näher erläutert werden.

In den zugehörigen Zeichnungen zeigen:
Fig. 1: eine Querschnittsdarstellung eines erfindungsgemäß ausgestatteten Indium-Targets mit angedeuteten Sputtergräben;
Fig. 2: ein verbrauchtes Indium-Target nach Fig. 1 mit Sputtergräben;
Fig. 3: eine perspektivische Darstellung einer Heizbank zur Herstellung von Indium-Targets.

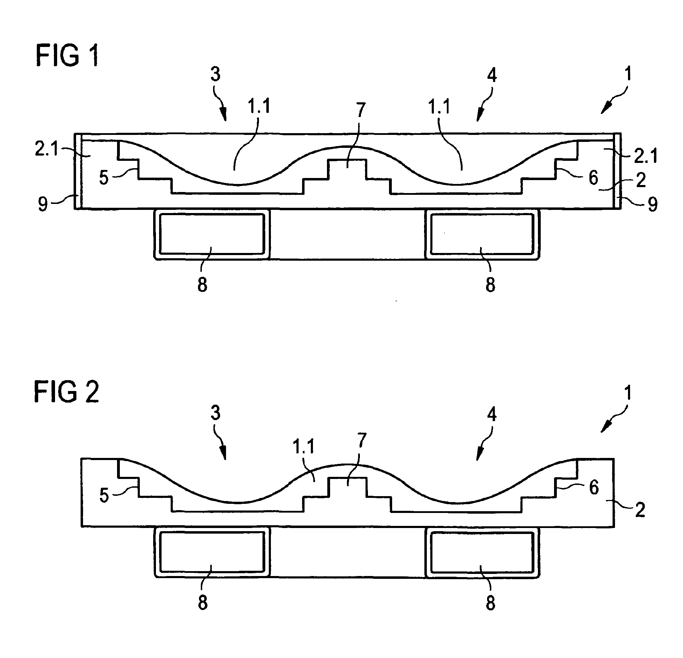

Das erfindungsgemäße Target 1 besteht aus einem flach ausgebildeten Kühlkörper 2, der unterhalb der sich im Gebrauch der Indium-Targets 1 sich längs desselben ausbildenden Sputtergräben 3, 4 unter jedem derselben mit einem zu diesem im wesentlichen formkongruenten in die Tiefe gehenden treppenförmigen Aussparungen 5, 6 mit einem flachen Steg 7 dazwischen versehen ist. In Fig. 1 sind die Sputtergräben durch eine gestrichelte Linie angedeutet. Die Aussparungen 5, 6 sind mit Indium 1.1 ausgefüllt und zwar derart, dass auch der Rand 2.1 des Kühlkörpers 2 mit Indium überdeckt wird. Die für die Herstellung der Indium-Targets 1 als auch die für deren Gebrauch notwendige Kühleinrichtung besteht aus mit dem Kühlkörper 2 verbundenen Kühlkanälen 8 mit rechteckigem Querschnitt, wobei die Kühlkanäle 8 auf der Unterseite des Kühlkörpers 2 angeordnet sind.

Wesentlich ist, dass die Aussparungen 5, 6 während des Gebrauchs der Indium-Targets 1 und dem dabei auftretenden Verschleiß durch die Ausbildung der Sputtergräben 3, 4 diese möglichst eng umschließen.

Der Kühlkörper 2 und die Kühlkanäle bestehen aus Kupfer und sind im Interesse eines guten Wärmeübergangs durch Löten miteinander verbunden.

Mit der erfindungsgemäßen Ausgestaltung des Indium-Targets 1 gelingt es erstmalig, eine besonders gute Kühlleistung insbesondere durch die Aussparungen 5, 6 in Verbindung mit den Kühlkanälen 8 außerhalb des Kühlkörpers 2 bereitzustellen.

Somit können Indium-Targets 1 mit ultra-feinkörnigem Gefüge hergestellt werden. Darüber hinaus erlaubt die Gestaltung der Aussparungen 5, 6 im Kühlkörper 2 in Verbindung mit der Kühlleistung eine wesentlich bessere Ausnutzung der Indium-Targets 1, woraus eine signifikante Erhöhung der Standzeit resultiert. Damit können auch gleichzeitig die Kosten reduziert werden.

In einer ersten Ausgestaltung der Erfindung sind die Seitenwände der Aussparung treppenförmig abgestuft und zwar derart, dass die Mittellinie der Abstufungen die Form des Sputtergrabens abbildet und wobei zwischen zwei Aussparungen ein Steg ausgebildet wird. Damit wird die Form der Sputtergräben angenähert realisiert, was bei verringertem Aufwand zu nahezu dem gleichen Ergebnis führt.

Die Aussparungen im Kühlkörper können spanabhebend, insbesondere durch Fräsen oder durch Formfräsen hergestellt werden.

Weiterhin weisen die Kühlkanäle einen rechteckigen Querschnitt auf und sind mit der größt möglichen Fläche mit dem Kühlkörper fest verbunden.

Schließlich ist es von Vorteil, wenn die Kühlkanäle 8, der Kühlkörper 2 und der Gießrahmen 9 aus dem gleichen gut Wärme leitenden Material, wie Kupfer, bestehen. Auf diese Weise können während des Aufheizvorganges sonst zu befürchtende Verwerfungen infolge thermischer Spannungen vermieden werden.

Das ist umso wichtiger, da bei der Länge der Indium-Targets 1 bereits geringste Verwerfungen zu Schwierigkeiten beim Gießen führen würden, da der Gießvorgang eine absolut horizontale Planlage des Kühlkörpers 2 und des Gießrahmens 9 über die gesamte Länge voraussetzt.

Im Interesse eines guten Wärmeüberganges sind die Kühlkanäle 8, die sich über die gesamte Länge des Kühlkörpers 2 erstrecken und mindestens in zwei nicht dargestellte Teilkreisläufe aufgeteilt und sind mit diesem verlötet, wobei der Kühlwasserzu- und Ablauf in der Mitte zwischen den beiden Kühlkreisläufen angeordnet ist.

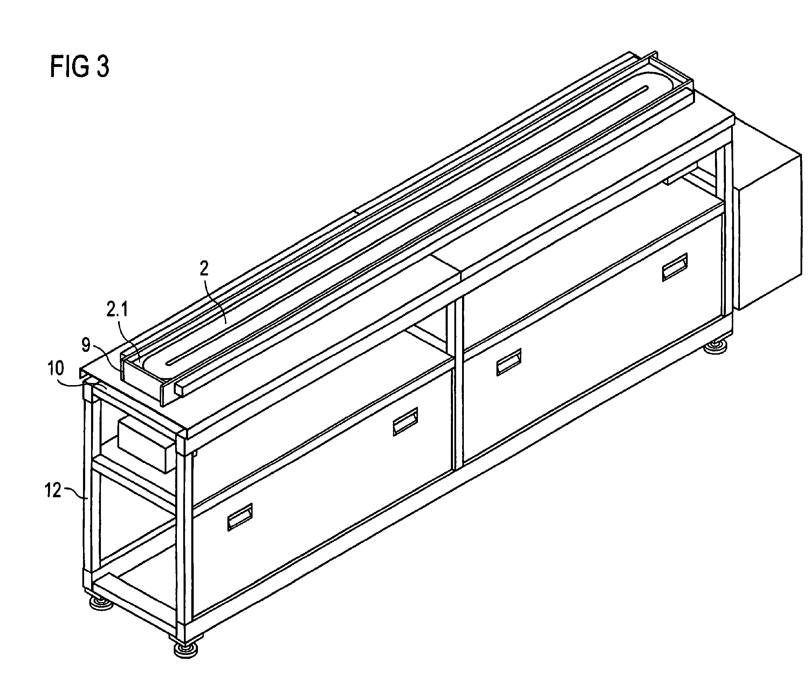

Die Anordnung zum Herstellen von ultra-feinkörnigen Indium-Targets besteht aus einer Heizbank 10 (Fig. 3) mit stabilem Unterbau 12, auf dem der Kühlkörper 2 aufliegt. Weiterhin wird der Kühlkörper 2 durch den Gießrahmen 9 dicht schließend umgeben. Wesentlich ist, dass der Kühlkörper 2 und der Gießrahmen 9 absolut horizontal auf der Heizbank 10 aufliegen. Die Kühlkanäle 8 der Kühleinrichtung des Kühlkörpers 2 sind mit einem nicht dargestellten Kühlkreislauf verbunden.

Weiterhin befinden sich in der Heizbank 10 unterhalb des Kühlkörpers 2 eine Heizvorrichtung 11 mit formschlüssig längs verschiebbar in diese eingelegten Heizelementen zur Ausbildung eines Temperaturprofiles mit möglichst homogener Temperaturverteilung über die Länge des Kühlkörpers 2 versehen ist.

Der Kühlkörper 2, die Kühlkanäle 8 und der Gießrahmen 11 bestehen aus Kupfer, wodurch eine besonders gute Wärmeleitfähigkeit gewährleistet ist.

Zum Herstellen von ultra-feinkörnigen Indium-Targets 2 wird die Heizbank 10 mit aufliegendem Kühlkörper 2 auf Gießtemperatur aufgeheizt und flüssiges Indium 1.1 in den Gießrahmen 11 gefüllt. Unmittelbar nach Beendigung des Gießprozesses und eine Beruhigungszeit wird vorgewärmtes Wasser durch die Kühlkanäle 8 gepumpt und eine computergesteuerte schnellstmögliche Abkühlung des Kühlkörpers 2 durch Steuerung von Menge und Geschwindigkeit des durch die Kühlkanäle 8 gepumpten Wassers durch Steuerung der Pumpenleistung realisiert. Erreicht wird die schnellstmögliche Abkühlung durch die rechteckigen Kühlkanäle 8 in Verbindung mit der erfindungsgemäßen Gestaltung des Querschnitts des Kühlkörpers 2.

Die erfindungsgemäß mit gesteuertem Abkühlprozess hergestellten Indium-Targets 1 sind zur Anwendung mit hoher Sputter-Leistung besonders geeignet.

Das ist dadurch möglich, dass solche Indium-Targets 1 mit ultra-feinkörnigem Gefüge eine besonders geringe Neigung zu Funkenentladungen (very low arcing) haben und Sputterraten mit 21,4 nm x m/min mit >1W/cm² bis 3W/cm² erlauben.

Die Geschwindigkeit der Abkühlung der Indiumschmelze kann durch die Menge/Geschwindigkeit des Kühlmediums, das durch die Kühlkanäle 8 gepumpt wird und durch dessen Temperatur mittels Steuerung der Temperatur des Kühlmediums und durch Steuerung der Pumpenleistung gesteuert werden.

Durch die Steuerung der Abkühlgeschwindigkeit und die besondere Gestaltung des Querschnitts des Kühlkörpers 2 sowie der Anordnung Kühlkanäle 8 mit größt möglichem Querschnitt ist es möglich, ultra-feinkörnige Indium-Targets herzustellen, die wiederum für den Schichtaufbau von Precursorschichten auf Substraten durch Sputtern der Indiumschicht besonders geeignet sind.

Die Precursorschichten können dann später thermisch in halbleitende CIGS-Schichten (**C**opper-**I**ndium-**G**allium-Di **S**elenid (oder CIS-Schwefel)-Schichten) für Solarzellen umgewandelt werden.

Durch die infolge der Erfindung erheblich verbesserte Schichtqualität der Indium-Schicht wird eine deutliche Verbesserung des Wirkungsgrades der Solarzellen insgesamt erreicht.

### Bezugszeichenliste

- 1: Indium-Target
- 1.1: Indium
- 2: Kühlkörper
- 2.1: Rand
- 3: Sputtergraben
- 4: Sputtergraben
- 5: Aussparung
- 6: Aussparung
- 7: flacher Steg
- 8: Kühlkanal
- 9: Heizbank
- 10: Heizvorrichtung

## Patentansprüche

1. Indium-Target für Sputtereinrichtungen aus ultra-feinkörnigem Gefüge zur Herstellung von Oberflächenbeschichtungen durch Sputtern, enthaltend einen mit einem Kühlkreislauf verbindbaren Kühlkörper mit mindestens einer Vertiefung, die mit Indium verfüllt ist, wobei sich das Indium auf einer Seite des Kühlkörpers über dessen gesamte Breite und Länge erstreckt, **dadurch gekennzeichnet, dass** der Kühlkörper (2) flach ausgebildet ist und unterhalb der sich im Gebrauch der Indium-Targets (1) ausbildenden Sputtergräben (3, 4) unter jedem derselben mit einer zu diesem im wesentlichen formkongruenten in die Tiefe gehenden Aussparung (5, 6) versehen ist und wobei die Kühleinrichtung in Form von mit dem Kühlkörper (2) verbundenen Kühlkanälen (8) ausgebildet ist, wobei die Kühlkanäle (8) auf der Unterseite des Kühlkörpers (8) angeordnet sind.

2. Indium-Target nach Anspruch 1, **dadurch gekennzeichnet, dass** die Seitenwände der Aussparungen (5, 6) treppenförmig abgestuft sind.

3. Indium-Target nach Anspruch 1 und 2, **dadurch gekennzeichnet, dass** die Mittellinie der Abstufungen die Form des Sputtergrabens (3, 4) abbildet.

4. Indium-Target nach Anspruch 1 bis 3, **dadurch gekennzeichnet, dass** zwischen zwei Aussparungen (5, 6) ein Steg (7) ausgebildet ist.

5. Indium-Target nach einem der Ansprüche 1 bis 4, **dadurch gekennzeichnet, dass** die Aussparungen (5, 6) spanabhebend, insbesondere durch Fräsen hergestellt sind.

6. Indium-Target nach Anspruch 5, **dadurch gekennzeichnet, dass** die Vertiefungen (5, 6) durch Formfräsen hergestellt sind.

7. Indium-Target nach einem der Ansprüche 1 bis 6, **dadurch gekennzeichnet, dass** die Kühlkanäle (8) einen rechteckigen Querschnitt aufweisen und mit dem Kühlkörper (2) fest verbunden sind.

8. Indium-Target nach Anspruch 7, **dadurch gekennzeichnet, dass** die Kühlkanäle (8)und der Kühlkörper (2) aus dem gleichen gut Wärme leitenden Material, wie Kupfer, bestehen.

9. Indium-Target nach Anspruch 7 oder 8, **dadurch gekennzeichnet, dass** die Kühlkanäle (8) mit dem Kühlkörper (2) verlötet sind, sich über dessen gesamte Länge erstrecken und mindestens in zwei Teilkreisläufe aufgeteilt sind, wobei der Kühlwasserzu- und Ablauf in der Mitte zwischen den beiden Kühlkreisläufen angeordnet ist.

10. Verwendung des Indium-Targets nach einem der Ansprüche 1 bis 8 für die Abscheidung von Indium auf Substraten durch Sputtern mit äußerst hoher Schichtqualität für CIGS-Anwendungen in der Solartechnik.

11. Anordnung zum Herstellen von Indium-Targets mit ultra-feinkörnigem Gefüge, **dadurch gekennzeichnet, dass** auf einer Heizbank (10) mit stabilem Unterbau (12) ein mit in die Tiefe gehenden Aussparungen (5, 6) und auf dessen Unterseite aufgelöteten Kühlkanälen (8) versehener flacher Kühlkörper (2) positioniert ist, der durch einen Gießrahmen (9) umgeben wird, wobei der Kühlkörper (2) und die Kühlkanäle (8) aus dem gleichen gut Wärme leitendem Material bestehen, dass die Kühleinrichtung mit einem Kühlkreislauf verbindbar ist, und dass die Heizbank (10) mit formschlüssig eingefügten und längs verschieblichen Heizelementen (11) zur Ausbildung eines Temperaturprofiles mit homogener Temperaturverteilung versehen ist.

12. Anordnung nach Anspruch 11, **dadurch gekennzeichnet, dass** der Kühlkörper (2) und die Kühlkanäle (8) aus Kupfer bestehen.

13. Verfahren zum Herstellen von Indium-Targets mit ultra-feinkörnigem Gefüge nach den Ansprüchen 1 bis 9 mit einer Vorrichtung gemäß Anspruch 11, **gekennzeichnet durch**
- Aufheizen der Heizbank (10) mit aufliegendem Kühlkörper (2) auf die Gießtemperatur von Indium sowie bündiges Einfüllen von flüssigem Indium in den Gießrahmen (9),
- Hindurchleiten einer Kühlflüssigkeit **durch** die Kühlkanäle (8) nach Beendigung des Gießprozesses sowie computergesteuerte Abkühlung der Kühlplatte **durch**
- Steuerung von Menge und Geschwindigkeit des **durch** die Kühlkanäle (8) gepumpten Kühlmediums **durch** Steuerung der Pumpenleistung.

## Claims

1. Indium target of an ultra fine-grained structure for sputtering devices for producing surface coatings by sputtering, comprising a heat sink, which can be connected to a cooling circuit and has at least one depression that is filled with indium, the indium extending on one side of the heat sink over the entire width and length thereof, **characterized in that** the heat sink (2) is of a flat form and is provided underneath the sputtering trenches (3, 4) that form during the use of the indium target (1), under each of the same, with a depthwise recess (5, 6) substantially congruent in shape with said trench, and the cooling device taking the form of cooling channels (8) connected to the heat sink (2), the cooling channels (8) being arranged on the underside of the heat sink (8).

2. Indium target according to Claim 1, **characterized in that** the side walls of the recesses (5, 6) are graduated in the form of steps.

3. Indium target according to Claims 1 and 2, **characterized in that** the centre line of the graduations replicates the form of the sputtering trench (3, 4).

4. Indium target according to Claims 1 to 3, **characterized in that** a web (7) is formed between two recesses (5, 6).

5. Indium target according to one of Claims 1 to 4, **characterized in that** the recesses (5, 6) are produced by machining, in particular by milling.

6. Indium target according to Claim 5, **characterized in that** the depressions (5, 6) are produced by form milling.

7. Indium target according to one of Claims 1 to 6, **characterized in that** the cooling channels (8) have a rectangular cross section and are fixedly connected to the heat sink (2).

8. Indium target according to Claim 7, **characterized in that** the cooling channels (8) and the heat sink (2) consist of the same material of good heat conduction, such as copper.

9. Indium target according to Claim 7 or 8, **characterized in that** the cooling channels (8) are soldered to the heat sink (2), extend over the entire length thereof and are divided at least into two partial circuits, the cooling water inlet and outlet being arranged in the middle between the two cooling circuits.

10. Use of the indium target according to one of Claims 1 to 8 for depositing indium on substrates by sputtering with extremely high layer quality for CIGS applications in solar technology.

11. Assembly for producing indium targets with an ultra fine-grain structure, **characterized in that** a flat heat sink (2), which is provided with depthwise recesses (5, 6) and cooling channels (8) soldered onto the underside thereof and is surrounded by a casting frame (9) is positioned on a heating bench (10) with a stable substructure (12), the heat sink (2) and the cooling channels (8) consisting of the same material of good heat conduction, **in that** the cooling device can be connected to a cooling circuit, and **in that** the heating bench (10) is provided with heating elements (11) that are fitted with interlocking engagement and are longitudinally displaceable, for forming a temperature profile with homogeneous temperature distribution.

12. Assembly according to Claim 11, **characterized in that** the heat sink (2) and the cooling channels (8) consist of copper.

13. Method for producing indium targets with an ultra fine-grained structure according to Claims 1 to 9 by a device according to Claim 11, **characterized by**
- heating up the heating bench (10) with the heat sink (2) lying on it to the casting temperature of indium and filling the casting frame (9) up to the top with liquid indium,
- passing a cooling fluid through the cooling channels (8) after completion of the casting process and computer-aided cooling of the cooling plate by
- controlling the amount and rate of the cooling medium pumped through the cooling channels (8) by controlling the pump output.

## Revendications

1. Cible d'indium pour installations de pulvérisation,
la cible étant constituée d'un réseau à grains ultrafins et étant destinée à réaliser des revêtements de surface par pulvérisation,
la cible contenant un corps de refroidissement qui peut être relié à un circuit de refroidissement et qui présente au moins un creux rempli d'indium,
l'indium s'étendant sur la totalité de la largeur et de la longueur d'un côté du corps de refroidissement,
**caractérisée en ce que**
le corps de refroidissement (2) est plat et est doté en dessous de chacun des sillons de pulvérisation (3, 4) qui se forment lorsque la cible d'indium (1) est utilisée d'une découpe (5, 6) de forme essentiellement congruente à celle du sillon et qui s'étend dans le sens de sa profondeur,
**en ce que** le dispositif de refroidissement est configuré sous la forme de canaux de refroidissement (8) reliés au corps de refroidissement (2) et
**en ce que** les canaux de refroidissement (8) sont disposés sur le côté inférieur du corps de refroidissement (8).

2. Cible d'indium selon la revendication 1, **caractérisée en ce que** les parois latérales des découpes (5, 6) sont étagées en escalier.

3. Cible d'indium selon les revendications 1 et 2, **caractérisée en ce que** la ligne centrale des gradins définit la forme du sillon de pulvérisation (3, 4).

4. Cible d'indium selon les revendications 1 à 3, **caractérisée en ce qu'**une nervure (7) est formée entre deux découpes (5, 6).

5. Cible d'indium selon l'une des revendications 1 à 4, **caractérisée en ce que** les découpes (5, 6) sont réalisées par enlèvement de matière et en particulier par fraisage.

6. Cible d'indium selon la revendication 5, **caractérisée en ce que** les creux (5, 6) sont réalisés par fraisage de façonnage:

7. Cible d'indium selon l'une des revendications 1 à 6, **caractérisée en ce que** les canaux de refroidissement (8) ont une section transversale rectangulaire et sont reliés solidairement au corps de refroidissement (2).

8. Cible d'indium selon la revendication 7, **caractérisée en ce que** les canaux de refroidissement (8) et le corps de refroidissement (2) sont constitués d'un même matériau bon conducteur de la chaleur, par exemple le cuivre.

9. Cible d'indium selon les revendications 7 ou 8, **caractérisée en ce que** les canaux de refroidissement (8) sont brasés sur le corps de refroidissement (2), s'étendent sur la totalité de la longueur de ce dernier et sont divisés en au moins deux circuits partiels, l'apport et l'enlèvement de l'eau de refroidissement étant disposés au milieu entre les deux circuits de refroidissement.

10. Utilisation de la cible d'indium selon l'une des revendications 1 à 8 pour le dépôt de couches d'indium de qualité extrêmement élevée pulvérisées sur des substrats pour applications CIGS en technique solaire.

11. Ensemble de fabrication de cibles d'indium à réseau à grains ultrafins,
**caractérisé en ce que**
un corps de refroidissement (2) plat doté de découpes (5, 6) qui s'étendent dans le sens de sa profondeur et de canaux de refroidissement (8) brasés sur son côté inférieur est placé sur une table chauffante (10) dotée d'une sous-structure (12) stable et est entouré par un cadre de coulée (9),
**en ce que** le corps de refroidissement (2) et les canaux de refroidissement (8) sont constitués d'un même matériau bon conducteur de la chaleur,
**en ce que** le dispositif de refroidissement peut être relié à un circuit de refroidissement et
**en ce que** la table chauffante (10) est dotée d'éléments chauffants (11) insérés en correspondance géométrique et aptes à coulisser longitudinalement de manière à former un profil de température à répartition homogène de la température.

12. Ensemble selon la revendication 11, **caractérisé en ce que** le corps de refroidissement (2) et les canaux de refroidissement (8) sont constitués de cuivre.

13. Procédé de fabrication de cibles d'indium à réseau en grains ultrafins selon les revendications 1 à 9 à l'aide d'un dispositif selon la revendication 11, le procédé étant **caractérisé par** les étapes qui consistent à :
- chauffer jusqu'à la température de fusion de l'indium la table chauffante (1) sur laquelle un corps de refroidissement (2) a été posé et insérer à chant de l'indium liquide dans le cadre de coulée (9),
- faire passer un liquide de refroidissement dans les canaux de refroidissement (8) lorsque l'opération de coulée est terminée et refroidir la plaque de refroidissement sous le contrôle d'un ordinateur
- en commandant le débit et la vitesse du fluide de refroidissement pompé dans les canaux de refroidissement (8) par l'intermédiaire du contrôle du débit de pompage.
